# EUROPEAN PATENT APPLICATION

(11) **EP 4 517 137 A1**
(43) Date of publication of application: **05.03.2025**
(21) Application number: 23193758.2
(22) Date of filing: 28.08.2023
(51) Int. Cl.: F16J 15/10, F16J 15/12, G03F 7/00, H01J 37/32

(54) **IMPROVED SEAL**

(71) Applicant: ASML Netherlands B.V., 5500 AH Veldhoven (NL)
(72) Inventor: POSTMA, Ludolf, 5500 AH Veldhoven (NL); KRAMER, Gijs, 5500 AH Veldhoven (NL)
(74) Representative: ASML Netherlands B.V.

(57) **Abstract**

There is provided a seal for use in a target material storage or supply system, wherein the seal comprises a polyimide core and a coating. Also provided is a target material storage or supply system including such a seal as well as an EUV light source comprising such a seal or target material storage or supply system. Also described is an EUV utilization system including the seal, target material storage or supply system, or EUV light source (1), optionally wherein the EUV utilization system is a lithographic system (LA) or an inspection system. A method of manufacturing a seal, the method including providing a polyimide core and providing a coating on the polyimide core is also described. Further provided is the use of such a seal, target material storage or supply system, EUV light source, EUV utilization system, or method in a lithographic method or apparatus, or EUV inspection method or apparatus.

## Description

### FIELD

The present disclosure relates to a seal for use in a target material storage or supply system. The present disclosure also relates to a target material storage or supply system including such a seal, as well as an EUV utilization apparatus or system, such as a lithographic system or an inspection system, including such a seal, or target material storage or supply system. The present disclosure also relates to a method of manufacturing a seal, and the use of such a seal, target material storage or supply system lithographic system, or method in a lithographic method or apparatus or inspection method or apparatus. The present disclosure has particular, but not exclusive application, to EUV utilization apparatuses, such as EUV lithographic systems or an inspection system, which rely on target materials to generate EUV light.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate, which may also be referred to as a wafer, is supported within the lithographic apparatus by a wafer table.

Certain lithographic apparatuses which use EUV radiation create the radiation beam by illuminating droplets of a target material with a laser. The EUV source creating such radiation is sometimes referred to as Laser Produced Plasma source. The laser converts the target material into a plasma, which subsequently releases EUV radiation, which can be collected and formed into a radiation beam. The droplets of target material are generated by a droplet generator assembly, which is supplied with the target material from a target material storage assembly. The target material is often molten tin, but other target materials, such as xenon or lithium may be used. Due to the relatively high pressures of target material and the nature of the liquid target material itself, there is a risk of leakage of the liquid target material. In addition, molten tin is not compatible with many materials and causes damage to such non-compatible materials, which can lead to contamination of the molten tin or failure of the non-compatible material.

The present invention has been provided with a view to addressing at least some of the drawbacks of existing systems.

### SUMMARY

According to a first aspect of the present disclosure, there is provided a seal for use in a target material storage or supply system, wherein the seal comprises a polyimide core and a coating.

Polyimide is compatible with the use of molten tin as a target material and can be formed into multiple shapes and is therefore eminently suitable to form the core of a seal. Whilst polyimide is stable to exposure to molten tin over extended periods of time, such as over two years, it has been found that exposure to atmospheric oxygen degrades the polyimide and leads to cracking. Such cracking limits the lifespan of seals made from polyimide and risks the seal failing prematurely, which could cause danger due to spillage of the molten target material, contamination of the target materials, as well as unexpected downtime of any apparatus, such as an EUV utilization apparatus, for example a lithographic apparatus or an inspection system, which is being supplied with the target material. Coating the polyimide core serves to slow the degradation of the polyimide material and thereby extend the life of the seal. By extending the lifespan of the seal, there is less downtime spent on maintenance and a lower risk of failure of the seal. The target material is preferably tin.

The coating may be an oxygen-barrier coating. Certain coating materials offer advantageous oxygen-barrier characteristics and, assuming that the oxygen barrier coating is either inert to exposure to molten tin or does not come into contact with molten tin, any known oxygen barrier coating material may be used.

The coating may be a metallic coating. The coating may be a refractory metal, preferably selected from molybdenum, tantalum, tungsten, or any combination thereof. In some embodiments, the coating may be exposed to the target material during use and so, in such cases, it is preferable to provide materials which are compatible with molten tin. By compatible, it is understood that the material will not be damaged by or contaminate the molten tin upon constant, direct exposure to the target material, such as molten tin.

The thickness of the coating may be from around 10 nm to around 1 micron. If the thickness of the coating is too small, the protection provided by the coating will be reduced and the operational lifespan of the seal will not be extended sufficiently. On the other hand, if the coating is too thick, there is an increased risk of delamination of the coating from the polyimide core.

The polyimide may be an unfilled polymer. As such, it may be free from any fillers, which could potentially contaminate the target material.

The coating may be a sputtered coating. The coating may be a physical vapour deposition coating. Such coatings can be uniform in thickness and provide a strong bond to the polyimide core.

The seal may be an O-ring seal. The O-ring seal may include a central opening, an inner land surrounding the central opening, and an outer land surrounding the inner land. The coating may be provided on the outer land and the inner land. Alternatively, the coating may be provided on the outer land and the inner land may be free from the coating. The seal may have any suitable cross section. The seal may have an O-shaped cross section, a C-shaped cross section, a T-shaped cross section, a Y-shaped cross section, or an X-shaped cross section.

The central opening in an O-ring seal allows for the passage of target material therethrough. The inner and outer lands define different portions of the seal and may serve different functions. The inner land may provide a mating surface which engages with the rigid fittings, such as pipes, which are connected with the seal in between. The inner land may therefore partially form a portion of the path through which target material flows and therefore comes into contact with the target material in use. The outer land may be exposed to oxygen and degrade over time due to such exposure to oxygen. By providing the coating on the outer land, the rate of oxidation of the material forming the outer land is reduced and so the lifespan of the seal is extended. Providing the coating material on both the inner land and the outer land may be preferable from a manufacturing perspective since the coating material can be provided uniformly over the seal without additional masking steps. As long as the coating material is compatible with the target material, that is to say it will not contaminate the target material or become damaged by direct contact with the target material, it is acceptable for the coating to be provided on the inner land. Alternatively, the inner land may be free from coating material. Whilst this may be more difficult from a manufacturing perspective, it allows the use of coating materials which are non-compatible with the target material. In addition, by having an inner land free from coating, there is no possibility of the coating material detaching from the polyimide core and contaminating the target material or otherwise causing damage downstream.

The outer land and the inner land may be stepped apart. The outer land and the inner land may define respective planes. Such respective planes may be parallel or substantially parallel, but separated by a distance. The seal may be symmetric with two faces, each face having an inner land and an outer land defining respective planes. As such, a seal may have two inner lands, each on an opposing face of the seal, and two outer lands, each on an opposing face of the seal. The material forming the inner land may be thinner than the material forming the outer land such that there is a rim or lip between the inner land and the outer land. In use, two elements which are connected via the seal, such as two pipes, may engage with the inner land such that ends of the two elements connected via the seal are below the plane of the outer land. In this way, the rim or lip provides additional sealing capability.

According to a second aspect of the present disclosure, there is provided a target material storage or supply system including a seal according to the first aspect of the present disclosure.

A target material storage or supply system may include various reservoirs, pipes, and valves to store and supply the target material. Where such components are connected, a seal may be provided. By extending the lifespan of the seals, it is possible to reduce the amount of downtime for replacing the seals and thereby maximise uptime of the apparatus.

It will be appreciated that in the present disclosure, the target material storage or supply system and the use thereof is not limited to the use as part of or with a lithographic system. It can be used with any other EUV utilization apparatus, such as, for example, an inspection apparatus, or more specifically a mask inspection apparatus. Such inspection apparatus may be configured to inspect a mask for potential defects. This could be achieved by illuminating the mask by EUV light generated by means of an EUV source vessel, namely a vessel in which EUV light is generated, supplied with target material by apparatuses or systems described herein. The inspection apparatus may include an illumination system and an optical detection system. The EUV light may be reflected by means of the optical detection system to the mask to be inspected. In this way, an image may be formed on a detector. This detector could, for example, be a time delay integration camera.

The target material storage or supply system may include a first and a second reservoir configured to hold liquid metal. The first reservoir may be in fluid communication with the second reservoir at least partially via a liquid metal transportation conduit. A refill assembly for an EUV light source may include a first reservoir, and a second reservoir. The first reservoir may receive liquid tin as target material and store the liquid tin. When the second reservoir requires refilling, liquid tin from the first reservoir may be transferred via a liquid metal transportation conduit to the second reservoir. The reservoirs may be configured to be pressurised by a gas, such as forming gas comprising argon and hydrogen. The reservoirs may be pressurised such that the liquid metal contained therein is discharged through the connection assembly to provide liquid metal to a droplet generator assembly. Due to the high pressures involved when transporting target material, particularly molten tin, seals are provided between joints to prevent leakage of the target material.

The second reservoir may be in fluid communication with a droplet generator assembly configured to generate droplets of the target material, such as molten tin. In order to generate EUV light, the droplets are illuminated by a laser within a source vessel, which turns them into a plasma. The plasma releases energy in the form of electromagnetic radiation, including EUV radiation, which can then be used in a lithographic process. As such, the first reservoir and the second reservoir can be in fluid communication with the droplet generator assembly and a priming system, for example as described in WO2020/187617, the contents on which are incorporated herein by reference in its entirety.

The first reservoir may be in fluid communication with a liquid metal refill assembly. The liquid metal refill assembly may be configured to receive an ingot of metal, such as tin, which is to be used as the fuel or target material in an EUV light source. The liquid metal may be transferred to the first reservoir for storage.

The target material storage or supply system may include one or more freeze valves operable to control flow of liquid metal through the assembly. Freeze valves are able to prevent the flow of liquid metal by allowing the liquid metal to solidify therein, thereby blocking flow. The freeze valves can be opened by heating the freeze valves to above the melting point of the metal.

The target material storage or supply system may be configured to operate at pressure of up to 30 kpsi, up to 25 kpsi, up to 20 kpsi, up to 15 kpsi, up to 10 kpsi, up to 5 kpsi, optionally at pressures of 2 kpsi or higher, 3 kpsi or higher, or 4 kpsi or higher. A liquid tin supply system typically is operated under high pressure as this is required to provide the tin droplets which are illuminated by a laser beam to generate EUV radiation with sufficient speed. As such, it is very important to have adequate seals in the target material storage and supply system

According to a third aspect of the present disclosure, there is provided an EUV light source comprising the seal or target material storage or supply system according to the first or second aspects of the present disclosure. The EUV light source may include a source vessel in which EUV light is generated.

According to a fourth aspect of the present disclosure, there is provided an EUV utilization system, such as a lithographic system or inspection system, including the seal, target material storage or supply system, or EUV light source according to any preceding claim.

According to a fifth aspect of the present disclosure, there is provided a method of manufacturing a seal, the method including providing a polyimide core and providing a coating on the polyimide core.

The polyimide core is in the desired shape of the seal and the coating is provided to protect the polyimide material from oxidation. As such, the coating material is preferably an oxygen barrier material.

The method may include providing the coating by sputtering or physical vapour deposition. Both of these methods allow the coating material to be reliably provided on the polyimide core, and are particularly suitable when the coating is a metal, such as tungsten, tantalum or molybdenum.

The method may include providing a mask to cover an inner land of a polyimide O-ring seal core prior to the step of providing a coating on the polyimide seal core such that the inner land of the polyimide O-ring seal core is free from the coating. It will be appreciated that O-rings seals may have different cross sections, such as an O-shaped cross section, a C-shaped cross section, a T-shaped cross section, a Y-shaped cross section, or an X-shaped cross section.

As with the first aspect of the present disclosure, in some cases, it may be preferable to have the inner land free from the coating and this may be achieved by the provision of a mask which can be removed once the coating has been provided.

According to a sixth aspect of the present disclosure, there is provided the use of a seal according to the first aspect, a target material storage or supply system according to the second aspect, an EUV light source according to the third aspect, an EUV utilization system, such as a lithographic system or an inspection system, according to the fourth aspect or a method according to the fifth aspect in a lithographic method or apparatus or EUV inspection method or apparatus.

The features of any aspect of the present invention may be combined except where the features are mutually incompatible and all such combinations are explicitly considered and disclosed.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2a is a schematic plan view of a seal core according to an aspect of the present disclosure, and Figure 2b is a cross-section of the seal taken along line A-A;
- Figure 2c is a cross-section of a seal according to an aspect of the present disclosure in which a coating is provided on both the inner and outer lands, and Figure 2d is a cross-section of a seal according to an aspect of the present disclosure in which a coating is only provided on the outer land; and
- Figure 3 is a schematic depiction of a seal according to an aspect of the present disclosure sealing a joint between two pipes.

### DETAILED DESCRIPTION

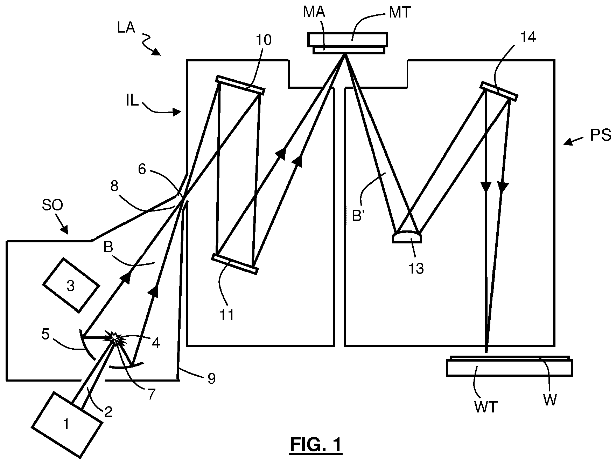

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W. Again, it will be appreciated that the present disclosure has application to any apparatuses and methods which utilize EUV radiation, and although the detailed description describes a lithographic system, the present disclosure is not necessarily limited to a lithographic system, but rather can be applied to any EUV utilization apparatus.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel also referred to as a target material, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma. The fuel emitter 3 may be part of a droplet generator assembly (not shown). The droplet generator assembly may be supplied with liquid tin via the connection assembly according to the present invention.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

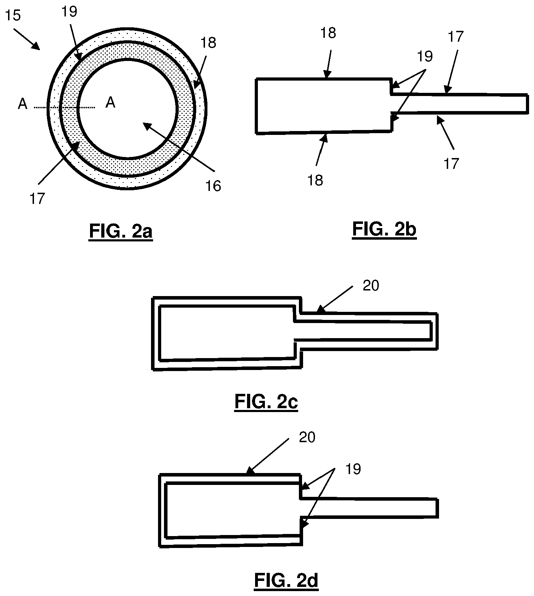

Figure 2a is a schematic depiction of a seal 15 according to the present disclosure. The seal 15 comprises a polyimide core and a coating. As depicted, the seal is an O-ring seal including a central aperture 16 surrounded by an inner land 17. The seal 15 also includes an outer land 18 which surrounds the inner land 17. As depicted in Figure 2b, which is a cross-section of the polyimide core through line A-A, the seal has an elongate T-shaped cross section, with the inner land 17 being stepped inwardly from the outer land 18. In the depicted embodiment, both faces of the inner land are stepped inwardly from both faces of the outer land 18, such that the inner land 17 portion of the seal 15 is thinner than the outer land 18 portion. This results in the presence of a rim or lip 19 at the interface between the inner land 17 and the outer land 18. In use, the rim or lip 19 may serve to enhance the sealing ability of the seal 15 by abutting the side of a pipe and also prevent or reduce movement of the seal 15.

Figure 2c depicts a cross-section of one embodiment of the present disclosure in which a coating 20 is provided and covers both the inner land 17 and the outer land 18. Figure 2d depicts an alternative embodiment in which the coating 20 only covers the outer land 18, leaving the inner land 17 free from the coating 20. Coating material may be provided on the rim or lip 19 in some embodiments and, in other embodiments, the rim or lip 19 may be free from coating material.

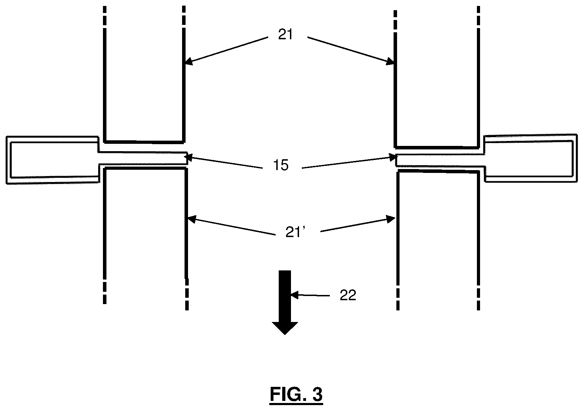

Figure 3 depicts a cross-section through a joint connecting two pipes or fittings 21, 21' via seal 15. It will be appreciated that the figures are schematic in nature and do not necessarily reflect the relative dimensions of the components in practice. In use, a target material flows through the lumen 16 of the joint in a flow direction 22. The inner land 17 of the seal 15 lies between ends of a pipe or fitting 21, 21' to provide a seal therebetween. As target material flows through the joint, it comes into contact with the inner land 17 of the seal 15. The material of the inner land is selected to be compatible with the target material and so is unaffected by this contact. The outer land 18 is exposed to oxygen and is separate from the target material. Without the protective coating 20, the outer land 18 has been found to oxidize over time, which can lead to failure of the seal. The protective coating 20 reduces the rate at which the material of the outer land 18 degrades and thereby extends the lifespan of the seal, thereby reducing the maintenance requirements.

In summary, the present disclosure provides for a means of reducing the maintenance requirements of an EUV utilization apparatus, such as a lithographic apparatus or system, or inspection system or apparatus, by the provision of a seal which is compatible for use with a target material, such as tin, and which has enhanced lifespan characteristics provided by the presence of a protective coating on the seal.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A seal for use in a target material storage or supply system, wherein the seal comprises a polyimide core and a coating.

2. The seal according to claim 1, wherein the coating is an oxygen-barrier coating.

3. The seal according to any preceding claim, wherein the coating is a metallic coating.

4. The seal according to any preceding claim, wherein the coating is a refractory metal, preferably selected from molybdenum, tantalum, tungsten, or any combination thereof.

5. The seal according to any preceding claim, wherein the thickness of the coating is from around 10 nm to around 1 micron.

6. The seal according to any preceding claim, wherein the polyimide is an unfilled polymer.

7. The seal according to any preceding claim, wherein the coating is a sputtered coating or a physical vapour deposition coating.

8. The seal according to any preceding claim, wherein the seal is an O-ring seal including a central opening, an inner land surrounding the central opening, and an outer land surrounding the inner land, wherein the coating is provided on the outer land and the inner land, or wherein the coating is provided on the outer land and the inner land is free from the coating.

9. The seal according to claim 8, wherein the outer land and the inner land are stepped apart.

10. A target material storage or supply system including a seal according to any preceding claim.

11. An EUV light source comprising the seal or target material storage or supply system according to any preceding claim.

12. An EUV utilization system including the seal, target material storage or supply system, or EUV light source according to any preceding claim, optionally wherein the EUV utilization system is a lithographic system or an inspection system.

13. A method of manufacturing a seal, the method including providing a polyimide core and providing a coating on the polyimide core.

14. The method according to claim 13, wherein the method includes providing the coating by sputtering or physical vapour deposition.

15. The method according to claim 13 or claim 14, wherein the method includes providing a mask to cover an inner land of a polyimide O-ring seal core prior to the step of providing a coating on the polyimide seal core such that the inner land of the polyimide O-ring seal core is free from the coating.

16. The use of a seal according to any of claims 1 to 9, a target material storage or supply system according to claim 10, an EUV light source according to claim 11, an EUV utilization system according to claim 12, or a method according to any of claims 13 to 15 in a lithographic method or apparatus, or EUV inspection method or apparatus.
